# EUROPEAN PATENT APPLICATION

(11) **EP 4 722 428 A1**
(43) Date of publication of application: **08.04.2026**
(21) Application number: 24810947.2
(22) Date of filing: 13.05.2024
(51) Int. Cl.: C30B 29/36, C30B 25/20, C30B 33/00

(54) **SUBSTRATE FOR SIC SEMICONDUCTOR DEVICES, SIC BONDED SUBSTRATE, SIC POLYCRYSTALLINE SUBSTRATE, AND METHOD FOR PRODUCING SIC POLYCRYSTALLINE SUBSTRATE**

(30) Priority: 25.05.2023 JP 2023086412
(71) Applicant: SUMITOMO METAL MINING CO., LTD., Tokyo 105-8716 (JP)
(72) Inventor: TAHARA, Daisuke, Tokyo 105-8716 (JP); AOKI, Katsutoshi, Tokyo 105-8716 (JP); MATSUOKA, Minori, Tokyo 105-8716 (JP)
(74) Representative: TBK
(86) International application number: PCT/JP2024/017618
(87) International publication number: WO 2024/241940

(57) **Abstract**

Provided is a substrate for a SiC semiconductor device, a SiC bonded substrate, a SiC polycrystalline substrate, and a SiC polycrystalline substrate manufacturing method, which can sufficiently suppress an amount of warping of the substrate after back grinding in the substrate for a SiC semiconductor device having a structure in which the SiC polycrystalline substrate and a SiC single crystal substrate are bonded.

A substrate for a SiC semiconductor device, wherein the device is formed by stacking a support substrate made of SiC polycrystalline, a SiC single crystal substrate bonded to a surface of the support substrate, a SiC single crystal epitaxial layer formed on the surface of the SiC single crystal substrate, and a component of a semiconductor element formed on the SiC single crystal epitaxial layer, in this sequence, wherein the surface of the support substrate that is not bonded to the SiC single crystal substrate is a ground surface, and wherein an amount of warping of the ground surface relative to a diameter of the ground surface is 0.17 mm/inch or less.

## Description

### Technical field

The present invention relates to a silicon carbide (hereinafter sometimes referred to as "SiC") polycrystalline substrate and its manufacturing method, a SiC bonded substrate obtained by bonding a SiC single crystal substrate to a SiC polycrystalline substrate, and a substrate for a SiC semiconductor device in which a SiC single crystal epitaxial layer and a semiconductor circuit are formed on the SiC bonded substrate.

### Background Art

SiC is a wide band gap semiconductor with a wide forbidden band width of 2.2 to 3.3 eV, and due to its excellent physical and chemical properties, it has been researched and developed as an environmentally resistant semiconductor material. In recent years, SiC has been attracting attention as a material for power devices such as high-voltage and high-power electronic devices and high-frequency electronic devices, as well as short-wavelength optical devices from blue to ultraviolet, and research and development of the material has become more active. However, it is difficult to manufacture high-quality large-diameter single crystals of SiC, which has hindered the practical use of SiC devices.

To solve this problem, an improved Lely method has been developed in which sublimation recrystallization is performed using a SiC single crystal substrate as a seed crystal. By using this improved Lely method, SiC single crystals can be grown while controlling the crystal polytype (4H-SiC, 6H-SiC, 15R-SiC, etc.), carrier type, and impurity concentration of the SiC single crystal. This technology has significantly reduced the crystal defect density, and the practical application of Schottky barrier diodes (SBDs) and field effect transistors (MOSFETs) on the substrate has progressed.

However, in the improved Lely method, which uses a SiC single crystal substrate as a seed crystal, the manufacturing cost of the SiC single crystal substrate is high due to the slow crystal growth rate and the high processing cost when processing the SiC single crystal ingot into a wafer through a step mainly consisting of cutting and polishing. This high manufacturing cost has also been a factor that has hindered the practical application of SiC devices, and there has been a strong demand for the development of technology that can provide SiC substrates for semiconductor device applications, especially for high-voltage, high-power electronic devices, at low cost.

Therefore, a technology has been provided for manufacturing a semiconductor substrate (hereinafter, sometimes referred to as a "SiC bonded substrate") that combines a low-cost support substrate portion with a high-quality SiC single crystal by using a high-quality SiC single crystal only for the device formation layer portion and fixing it to a support substrate (a material having strength, heat resistance, and cleanliness that can withstand the device manufacturing process: for example, SiC polycrystalline substrate) using a bonding method that does not involve the formation of an oxide film at the bonding interface (see, for example, Patent Literature 1). In particular, SiC bonded substrates using SiC polycrystalline as a support substrate have an advantage over using SiC single crystal substrates alone in that they enable reduced manufacturing costs while taking advantage of the properties of SiC single crystal when applied to power devices. With the spread of SiC single crystal substrates, attention is being paid to SiC bonded substrates that can be manufactured more inexpensively.

On the other hand, problems related to the "warping" of the substrate in the manufacturing process of devices using SiC single crystal substrates have also become apparent. In general, the degree of "warping" of the substrate is considered to be very important in the device manufacturing process. This is because a substrate with a large warp may cause an error in the automatic transport of devices in the device manufacturing process, or may cause a problem in which the substrate cannot be held on the processing table. In addition, even if the substrate can be held on the processing table due to the large warp of the substrate, the substrate may not be sufficiently flat, and for example, in the exposure step (lithography step), a part of the substrate surface may be out of focus and a clear mask image may not be formed. The effect of this defocus phenomenon is greater the finer the circuit. Also, the warp of the substrate may also be a cause for concern about a decrease in yield in the dicing step and the package assembly step. In response to this, for example, according to Patent Literature 2, in a single crystal SiC substrate having a surface in which processing damage is removed from the front and back of the substrate by CMP or diamond polishing, the substrate has a small warp of the substrate is provided, which is explained by the distortion and residual stress obtained by Raman spectroscopy and X-ray method. Also, according to Patent Literature 3, a SiC polycrystalline molded body having a small warp explained by the residual stress value measured by the X-ray method is provided.

### Citation List

### Patent Literature

Patent Literature 1: JP 2015-15401 A
Patent Literature 2: JP 2015-59073 A
Patent Literature 3: JP 2021-54666 A

### Summary of the invention

### Problems to be solved by the invention

Substrate warping also occurs during thinning processing after mounting the surface circuit pattern in the manufacturing process of a vertical power device in which the current flow direction is the thickness direction of the substrate, such as back grinding (BG). In this thinning processing process, it is necessary to remove about 40 % to 60 % of the original substrate thickness. For example, in a 6-inch diameter SiC single crystal substrate, the thickness after thinning processing by grinding is about 150 µm to 200 µm compared to the plate thickness of 350 µm, so the amount of grinding is large, and grinding processing with high processing efficiency is generally adopted. In a substrate for a semiconductor device using a SiC single crystal substrate that is not bonded, the substrate warp is suppressed to about 1 mm or less, and no problems due to the above-mentioned warp occur. In contrast, in the case of a SiC bonded substrate in which a SiC polycrystalline substrate and a SiC single crystal substrate are bonded, the warp after back grinding exceeds 1 mm, and there is a risk of problems due to the warp occurring in the later step, such as transport errors of the substrate and problems in which the substrate cannot be held on the processing table. In particular, when the amount of back grinding exceeds the thickness of the substrate, the amount of warpage becomes extremely worse. This is thought to be because the thickness of the substrate becomes thinner, the rigidity of the substrate itself becomes smaller, and the balance of internal stress is lost.

This warping during back grinding occurs because a processing damage layer is generated on the back surface of the substrate by the grinding step, and the difference in the state of the processed surfaces on the front and back of the substrate causes the Twyman effect, resulting in large warping of the substrate. On the other hand, in chemical mechanical polishing (CMP), which does not involve a processing damage layer, large warping of the substrate is unlikely to occur, but the polishing speed is very slow, about 1/100, compared to grinding, and the cost is high. Therefore, back grinding is essential for thinning the substrate, rather than polishing.

Therefore, from the viewpoint of cost and manufacturing efficiency, if it is possible to provide a substrate that is less likely to warp during back grinding, assuming that only back grinding is used for thinning, the process window for grinding that can be finished to the desired processed state will be widened, and it is thought that it will be easier to optimize the back grinding design in the device manufacturing process.

The present invention has been made in view of these problems, and has an object to provide a substrate for a SiC semiconductor device, a SiC bonded substrate, a SiC polycrystalline substrate, and a SiC polycrystalline substrate manufacturing method, which can sufficiently suppress an amount of warping of the substrate after back grinding in the substrate for a SiC semiconductor device having a structure in which the SiC polycrystalline substrate and a SiC single crystal substrate are bonded.

### Solution to Problem

In order to solve the above problem, a substrate for a SiC semiconductor device of the present invention is a substrate for a SiC semiconductor device, wherein the substrate is formed by stacking a support substrate made of SiC polycrystalline, a SiC single crystal substrate bonded to the surface of the support substrate, a SiC single crystal epitaxial layer formed on the surface of the SiC single crystal substrate, and a semiconductor element component formed on the SiC single crystal epitaxial layer, in this sequence, wherein the surface of the support substrate that is not bonded to the SiC single crystal substrate is a ground surface, and wherein an amount of warping of the ground surface relative to the diameter of the ground surface is 0.17 mm/inch or less.

In addition, in order to solve the above problems, a SiC bonded substrate of the present invention is formed by stacking a support substrate made of SiC polycrystalline, and a SiC single crystal substrate bonded to the surface of the support substrate, wherein an amount of warping of the ground surface relative to the diameter of the ground surface is 0.17 mm/inch or less in state that the thickness of the support substrate is ground by 40 % to 60 % to form the ground surface by performing a back grinding step on the surface of the support substrate that is not bonded to the SiC single crystal substrate.

In addition, in order to solve the above problems, a SiC polycrystalline substrate of the present invention is a SiC polycrystalline substrate used as a support substrate for a SiC bonded substrate, wherein the substrate is formed by stacking the support substrate made of SiC polycrystalline, and a SiC single crystal substrate bonded to the surface of the support substrate, wherein an amount of warping of the ground surface relative to the diameter of the ground surface is 0.17 mm/inch or less in state that the thickness of the support substrate is ground by 40 % to 60 % to form the ground surface by performing a back grinding step on the surface of the support substrate that is not bonded to the SiC single crystal substrate.

In addition, in order to solve the above problem, a method for manufacturing a SiC polycrystalline substrate of the present invention is a method for manufacturing a SiC polycrystalline substrate used as a support substrate for a SiC bonded substrate, wherein the support substrate made of SiC polycrystalline and a SiC single crystal substrate bonded to the surface of the support substrate are stacked, the method comprising: a film formation step of forming a SiC polycrystalline film on a seed substrate; a separation step of separating the seed substrate and the SiC polycrystalline film after the film formation step; a heat treatment step of heat treating the SiC polycrystalline film by holding the SiC polycrystalline film at 1600°C or higher and 2000°C or lower after the separation step; and a grinding and polishing step of grinding and polishing the SiC polycrystalline film to process it into the support substrate after the heat treatment step, wherein in the heat treatment step, the SiC polycrystalline film is heat-treated while maintaining a state in which a force is applied in a direction opposite to the direction of warping of the SiC polycrystalline film.

### Effects of the Invention

According to the present invention, it is possible to provide a substrate for a SiC semiconductor device, a SiC bonded substrate, a SiC polycrystalline substrate, and a SiC polycrystalline substrate manufacturing method, which can sufficiently suppress an amount of warping of the substrate after back grinding in the substrate for a SiC semiconductor device having a structure in which the SiC polycrystalline substrate and a SiC single crystal substrate are bonded.

### Brief Description of the Drawings

[Figure 1A] Schematic perspective view of a SiC polycrystalline substrate.
[Figure 1B] Schematic perspective view of a SiC polycrystalline substrate.
[Figure 2A] Schematic perspective view of a SiC bonded substrate.
[Figure 2B] Schematic perspective view of a SiC bonded substrate.
[Figure 3] Schematic cross-sectional view of a substrate for a SiC semiconductor device.
[Figure 4] Schematic cross-sectional view of a MOSFET, which is an example of a SiC semiconductor device.
[Figure 5] A flowchart showing an example of a method for manufacturing a support substrate and a SiC bonded substrate.
[Figure 6] A flowchart showing an example of a method for manufacturing a SiC semiconductor device.
[Figure 7A] A schematic side view showing a method for correcting warpage of a SiC polycrystalline film.
[Figure 7B] A schematic side view showing a method for correcting warpage of a SiC polycrystalline film.
[Figure 8A] A schematic side view showing a method for correcting warpage of a SiC polycrystalline film, different from that shown in Figure 7A and 7B.
[Figure 8B] A schematic side view showing a method for correcting warpage of a SiC polycrystalline film, different from that shown in Figure 7A and 7B.
[Figure 9A] A schematic view showing a method for correcting warpage of a SiC polycrystalline film, different from that shown in Figure 7A, 7B, 8A, and 8B.
[Figure 9B] A schematic view showing a method for correcting warpage of a SiC polycrystalline film, different from that shown in Figure 7A, 7B, 8A, and 8B.
[Figure 10] A schematic view showing a method for correcting warpage of a SiC polycrystalline film, different from that shown in Figure 7A, 7B, 8A, 8B, 9A, and 9B.

### Detailed Description of Embodiments

Hereinafter, an example of an embodiment of the present invention will be described in detail with reference to the drawings, but the present invention is not limited to the embodiment.

### [SiC polycrystalline substrate]

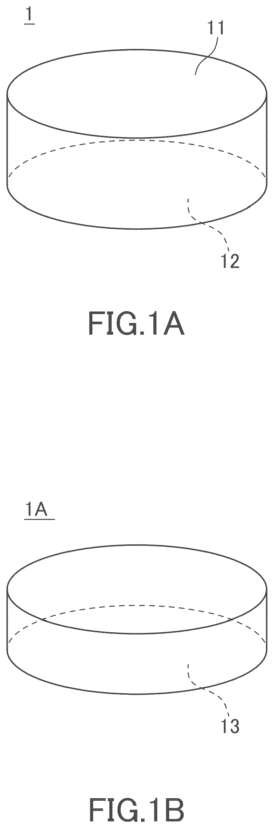

The SiC polycrystalline substrate is used as a support substrate for a SiC bonded substrate in which a support substrate made of SiC polycrystalline and a SiC single crystal substrate bonded to the surface of the support substrate are stacked. For example, as shown in FIG. 1A, it is a SiC polycrystalline substrate 1 formed of polycrystalline SiC formed by a CVD method. The SiC polycrystalline substrate 1 is disc-shaped with a thickness of 200 µm to 500 µm and a size of 4 inches to 8 inches in diameter. For example, it is formed into a 6-inch disc-shaped with a thickness of about 350 µm. The SiC polycrystalline of the SiC polycrystalline substrate 1 is composed of any one of 4H-SiC crystal, 6H-SiC crystal, and 3C-SiC crystal, or a mixture thereof. One inch is 25.4 mm.

For example, in the SiC polycrystalline substrate 1, if the surface 11 of the SiC polycrystalline substrate 1 is a surface that is bonded to the SiC single crystal substrate, the opposite surface 12 of the surface 11 is a surface that is not bonded to the SiC single crystal substrate, and in the process of manufacturing the SiC semiconductor device, the opposite surface 12 is back-ground to thin the SiC polycrystalline substrate 1. Also, the opposite surface 12 may be a surface that is bonded to the SiC single crystal substrate, in which case the surface 11 is a surface that is not bonded to the SiC single crystal substrate, and the surface 11 is back-ground.

By backgrinding the SiC polycrystalline substrate 1, when the thickness of the SiC polycrystalline substrate 1 is ground by 40 % to 60 % to form the ground surface 13 (the state of the SiC polycrystalline substrate 1A in FIG. 1B), the amount of warping of the ground surface 13 relative to the diameter of the ground surface 13 is 0.17 mm/inch or less.

By having the amount of warping of 0.17 mm/inch or less, problems caused by warping, such as substrate transport errors in later steps and failure to hold the substrate on the processing table, can be prevented.

For example, if the SiC polycrystalline substrate 1 is a disk-shaped substrate with a diameter of 4 inches, 6 inches, or 8 inches, the diameter of the ground surface 13 will be 4 inches, 6 inches, or 8 inches, respectively. The amount of warping of 0.17 mm/inch or less means that the amount of warping per inch is 0.17 mm or less. When the diameter of the ground surface 13 is 4 inches, the amount of warping of the ground surface 13 is 0.7 mm or less, when the diameter of the ground surface 13 is 6 inches, the amount of warping of the ground surface 13 is 1.0 mm or less, and when the diameter of the ground surface 13 is 8 inches, the amount of warping of the ground surface 13 is 1.4 mm or less, rounded off to one decimal place.

In order to more reliably prevent problems caused by warpage, such as substrate transport errors in subsequent steps and failure to hold the substrate on the processing table, it is preferable that the amount of warping of the ground surface 13 is 1.0 mm or less when the SiC polycrystalline substrate 1 is a disk shape with a diameter of 6 to 8 inches. That is, by having the amount of warping of 0.17 mm/inch or less, in the case of a disk-shaped SiC polycrystalline substrate 1 with a diameter of 6 inches or less, which is currently mainstream, problems caused by warpage, such as substrate transport errors in later steps and problems in which the substrate cannot be held on the processing table, can be more reliably prevented.

By performing back grinding on the SiC polycrystalline substrate 1, it is preferable that the amount of warping of the ground surface 13 relative to the diameter of the ground surface 13 is 0.085 mm/inch or less when the thickness of the SiC polycrystalline substrate 1 is ground by 40 % to 50 % to form the ground surface 13.

By having the amount of warping of 0.085 mm/inch or less, problems caused by warpage, such as substrate transport errors in later steps and problems in which the substrate cannot be held on the processing table, can be more reliably prevented.

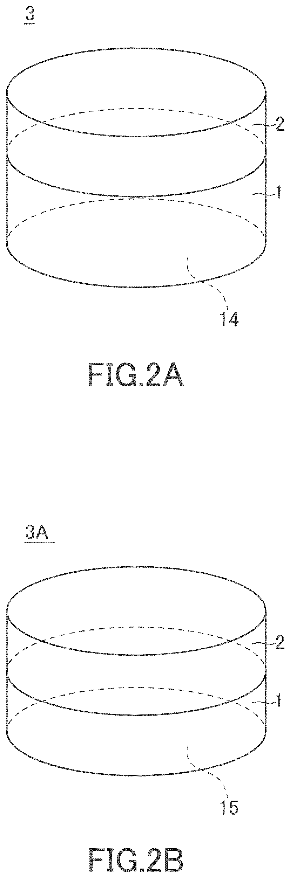

For example, if the size of the SiC polycrystalline substrate 1 is a disk shape with a diameter of 4 inches, 6 inches, or 8 inches, the diameter of the ground surface 13 is also 4 inches, 6 inches, or 8 inches, respectively. The amount of warping of 0.085 mm/inch or less means, rounded off to one decimal place, that the amount of warping of the ground surface 13 when the diameter of the ground surface 13 is 4 inches is 0.3 mm or less, the amount of warping of the ground surface 13 when the diameter of the ground surface 13 is 6 inches is 0.5 mm or less, and the amount of warping of the ground surface 13 when the diameter of the ground surface 13 is 8 inches is 0.7 mm or less. Furthermore, even if the diameter of the ground surface 15 is 12 inches, the amount of warping of the ground surface 15 is 1.0 mm or less (FIG. 2B), which is a level at which problems caused by warping, such as substrate transport errors in subsequent steps and problems in which the substrate cannot be held on the processing table, can be prevented.

In order to more reliably prevent problems caused by warping, such as substrate transport errors in subsequent steps and failure to hold the substrate on the processing table, for example, when the size of the SiC polycrystalline substrate 1 is a disk shape with a diameter of 6 to 8 inches, it is more preferable that the amount of warping of the ground surface 13 is 0.5 mm or less.

In the step of thinning the SiC polycrystalline substrate 1, about 40 % to 60 % of the original thickness of the SiC polycrystalline substrate 1 is removed by back grinding, but the extent to which the SiC polycrystalline substrate 1 is thinned depends on the allowable range of thickness unevenness of the SiC semiconductor device and the high density of the device.

Here, the SiC polycrystalline substrate 1 can be ground with a grinder using a grinding wheel of No. 5000 to No. 8000. The ground surface after grinding has a surface roughness Ra of 1 nm to 5 nm.

The amount of warpage of the ground surface 13 can be measured using a shape measuring device such as a three-dimensional measuring device.

### [SiC bonded substrate]

As shown in FIG. 2A, the SiC bonded substrate 3 includes a SiC polycrystalline substrate 1 and a SiC single crystal substrate 2 bonded to the surface of the SiC polycrystalline substrate 1. The SiC single crystal substrate 2 is a single crystal of SiC, and has a diameter of 4 to 8 inches, which is the same as the SiC polycrystalline substrate 1. There is no particular limit to the thickness, but the thickness may be, for example, about 0.5 µm to 2.0 µm. The SiC bonded substrate 3 is a substrate that combines a low-cost support substrate portion and high-quality SiC single crystal by using a high-quality SiC single crystal substrate 2 for the portion forming the components of the semiconductor device and bonding it to the SiC polycrystalline substrate 1, which is a support substrate.

The back surface 14 of the SiC polycrystalline substrate 1, which is the surface not bonded to the SiC single crystal substrate 2, is back-ground in the step of manufacturing the SiC semiconductor device, and the SiC polycrystalline substrate 1 is thinned. By performing back grinding on the SiC polycrystalline substrate 1, the thickness of the SiC polycrystalline substrate 1 is ground by 40 to 60% to form the ground surface 15 (the state of the SiC bonded substrate 3A in FIG. 2B), and the amount of the warpage of the ground surface 15 with respect to the diameter of the ground surface 15 is 0.17 mm/inch or less. The opposite surface 12 corresponds to the back surface 14, and the ground surface 13 corresponds to the ground surface 15.

By keeping the amount of warpage of 0.17 mm/inch or less, problems caused by warpage, such as substrate transport errors and failure to hold the substrate on the processing table in later steps, can be prevented.

For example, if the SiC polycrystalline substrate 1 is a disk-shaped substrate with a diameter of 4 inches, 6 inches, or 8 inches, the diameters of the ground surface 15 will also be 4 inches, 6 inches, or 8 inches, respectively. The amount of warpage of 0.17 mm/inch or less means, rounded off to one decimal place, that the warpage of the ground surface 15 is 0.7 mm or less when the diameter of the ground surface 15 is 4 inches, 1.0 mm or less when the diameter of the ground surface 15 is 6 inches, and 1.4 mm or less when the diameter of the ground surface 15 is 8 inches.

In order to more reliably prevent problems caused by warping, such as substrate transport errors and failure to hold the substrate on the processing table in later steps, it is preferable that the amount of warpage of the ground surface 15 is 1.0 mm or less when the SiC polycrystalline substrate 1 is a disk-shaped substrate with a diameter of 6 to 8 inches. In other words, by having the amount of warpage of 0.17 mm/inch or less, problems caused by warping, such as substrate transport errors and failure to hold the substrate on the processing table in later steps, can be more reliably prevented for the currently mainstream disk-shaped SiC polycrystalline substrate 1 with a diameter of 6 inches or less.

By performing back grinding on the SiC polycrystalline substrate 1, in the state that the ground surface 15 is formed by grinding the thickness of the SiC polycrystalline substrate 1 by 40 % to 50 %, it is preferable that the amount of warping of the ground surface 15 relative to the diameter of the ground surface 15 is 0.085 mm/inch or less.

By making the amount of warpage of 0.085 mm/inch or less, problems caused by warping, such as substrate transport errors and failure to hold the substrate on the processing table in later steps, can be more reliably prevented.

For example, if the size of the SiC polycrystalline substrate 1 is a disk shape with a diameter of 4 inches, 6 inches, or 8 inches, the diameters of the ground surface 15 are also 4 inches, 6 inches, and 8 inches, respectively. The amount of warpage of 0.085 mm/inch or less means, rounded off to one decimal place, that amount of warpage of the ground surface 15 when the diameter of the ground surface 15 is 4 inches is 0.3 mm or less, the amount of warpage of the ground surface 15 when the diameter of the ground surface 15 is 6 inches is 0.5 mm or less, and the amount of warpage of the ground surface 15 when the diameter of the ground surface 15 is 8 inches is 0.7 mm or less. Furthermore, even if the diameter of the ground surface 15 is 12 inches, the amount of warpage of the ground surface 15 is 1.0 mm or less, which is a level that can prevent problems caused by warping, such as substrate transport errors and problems in which the substrate cannot be held on the processing table in later steps.

In order to more reliably prevent problems caused by warping, such as substrate transport errors and problems in which the substrate cannot be held on the processing table in later steps, it is more preferable that the amount of warpage of the ground surface 15 is 0.5 mm or less when, for example, the SiC polycrystalline substrate 1 is a disk-shaped substrate with a diameter of 6 to 8 inches.

### [Substrate for SiC semiconductor device]

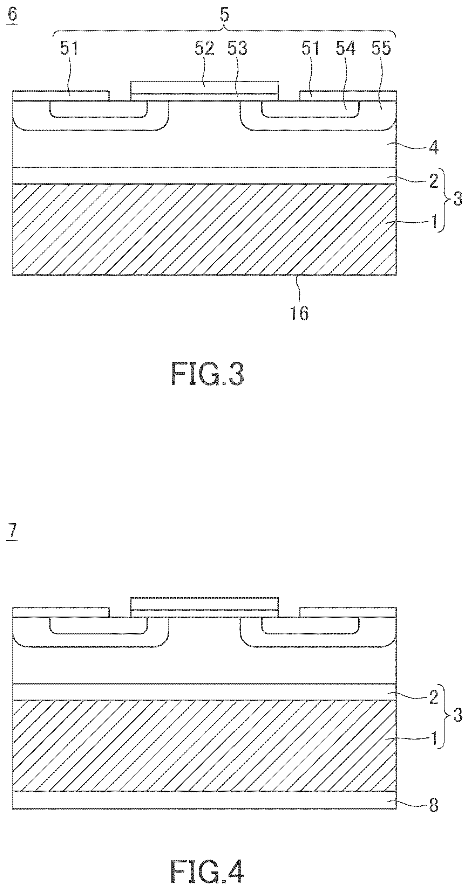

As shown in FIG. 3, the substrate 6 for a SiC semiconductor device is a substrate in which a SiC polycrystalline substrate 1, a SiC single crystal substrate 2 bonded to the surface of the SiC polycrystalline substrate 1, a SiC single crystal epitaxial layer 4 formed on the surface of the SiC single crystal substrate 2, and a semiconductor element component 5 formed on the SiC single crystal epitaxial layer 4 are laminated in this sequence. Here, the semiconductor element component 5 is not particularly limited, but for example, it is composed of a source electrode 51, a gate electrode 52, a gate insulating film 53, an N⁺ source 54, and a P well 55. The substrate 6 for a SiC semiconductor device is a substrate in a state before being divided into individual pieces.

The ground surface 16, which is the surface of the SiC polycrystalline substrate 1 that is not bonded to the SiC single crystal substrate 2, is back-ground in the process of manufacturing the SiC semiconductor device, and the SiC polycrystalline substrate 1 is thinned. By performing back grinding on the SiC polycrystalline substrate 1, the SiC polycrystalline substrate 1 is ground by 40% to 60% to reduce its thickness to form a ground surface 16, and the amount of warpage of the ground surface relative to the diameter of the ground surface 16 is 0.17 mm/inch or less. The ground surface 16 corresponds to the ground surface 13 and the ground surface 15.

By having the amount of warpage of 0.17 mm/inch or less, problems caused by warping, such as substrate transport errors and failure to hold the substrate on the processing table in later steps, can be prevented.

For example, if the SiC polycrystalline substrate 1 is a disk-shaped substrate with a diameter of 4 inches, 6 inches, or 8 inches, the diameters of the ground surface 16 are 4 inches, 6 inches, or 8 inches, respectively. The amount of warpage of 0.17 mm/inch or less means, rounded off to one decimal place, that the amount of warpage of the ground surface 16 is 0.7 mm or less when the diameter of the ground surface 16 is 4 inches, that the warpage of the ground surface 16 is 1.0 mm or less when the diameter of the ground surface 16 is 6 inches, and that the amount of warpage of the ground surface 16 is 1.4 mm or less when the diameter of the ground surface 16 is 8 inches.

In order to more reliably prevent problems caused by warpage, such as substrate transport errors and failure to hold the substrate on the processing table in later steps, it is preferable that the amount of warpage of the ground surface 16 is 1.0 mm or less when the SiC polycrystalline substrate 1 is a disk shape with a diameter of 6 to 8 inches. That is, by making the amount of warpage of 0.17 mm/inch or less, if the SiC polycrystalline substrate 1 is a disk-shaped substrate with a diameter of 6 inches or less, which is currently mainstream, problems caused by the warpage, such as substrate transport errors and failure to hold the substrate on the processing table in later steps, can be more reliably prevented.

### [SiC Semiconductor Device]

The SiC semiconductor device 7 of this embodiment is obtained by individually dividing the substrate for the SiC semiconductor device. Note that, as shown in FIG. 4, a semiconductor device for a vertical power device in which the current flows in the thickness direction of the substrate have a structure in which a drain electrode 8 is formed as a back electrode on the ground surface 16 of the substrate for the substrate 6 for a SiC semiconductor device.

### [Manufacturing Method of SiC polycrystalline Substrate]

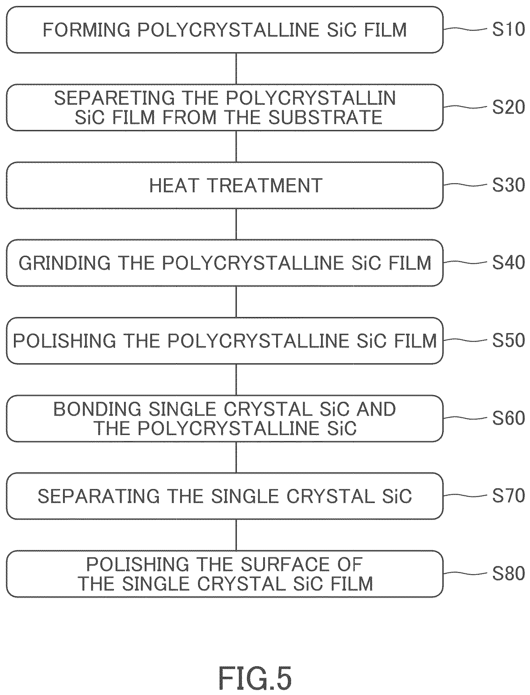

Next, a manufacturing method of a SiC polycrystalline substrate will be described. This manufacturing method is a method for manufacturing a SiC polycrystalline substrate 1 used as a support substrate in a SiC bonded substrate 3 in which a SiC polycrystalline substrate 1 serving as a support substrate and a SiC single crystal substrate 2 bonded to the surface of the SiC polycrystalline substrate 1 are stacked, and includes a film forming step, a separation step, a heat treatment step, and a grinding and polishing step, which will be described below. FIG. 5 is a flow chart of an example of a method for manufacturing the SiC polycrystalline substrate 1 serving as a support substrate and the SiC bonded substrate 3, and shows steps S10 to S80.

### <Step S10 (film formation step)>

In the manufacturing method of the SiC polycrystalline substrate 1, in step S10, a SiC polycrystalline film is formed on a seed substrate. A seed substrate made of carbon, silicon, or the like is used as a base substrate, and a SiC polycrystalline film is formed on the base substrate by a CVD method or the like.

### <Step S20 (separation step)>

Next, in step S20, the seed substrate and the SiC polycrystalline film are separated. For example, the base substrate on which the SiC polycrystalline film is formed can be removed by burning or dissolving with acid.

### <Step S30 (heat treatment step)>

In this embodiment, the object is to suppress the warping of the substrate 6 for a SiC semiconductor device caused by thinning the SiC polycrystalline substrate 1 by the back grinding step (step S110) described later, and for this purpose, a heat treatment step is performed.

When the SiC polycrystalline film after the separation step is separated from the seed substrate, warping of about several tens of µm occurs even before the back grinding step. The direction of the warp of the SiC polycrystalline film after this separation step can be determined by using a shape measuring device such as the above-mentioned three-dimensional measuring device, as well as by various simple measurements and visual inspection. In the heat treatment step, the SiC polycrystalline film is heat treated in a state where the warpage has been corrected. The warpage is corrected by maintaining a state where a force is applied to the SiC polycrystalline film in the direction opposite to the direction of the warpage of the SiC polycrystalline film.

For example, the SiC polycrystalline film is placed on a correction jig capable of correcting the warpage of the SiC polycrystalline film, and a weight is applied from above to correct the shape so that a force in the direction opposite to the warpage of the SiC polycrystalline film is applied (for example, so that the SiC polycrystalline film warps in the direction opposite to the warpage of the SiC polycrystalline film), and heat treatment is performed while maintaining this state. By performing heat treatment while applying stress to the SiC polycrystalline film by the correction jig, it is possible to relieve the internal stress of the SiC polycrystalline film so as to suppress the warpage of the SiC polycrystalline film after the grinding step described below.

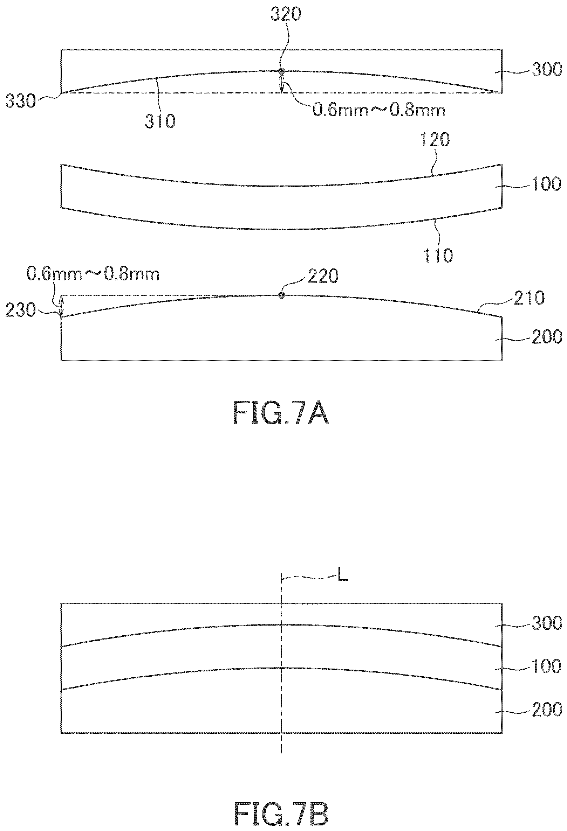

The correction jig is not particularly limited as long as it has a shape that can correct the warpage of the SiC polycrystalline film. In addition, the correction jig may be made of a material such as graphite or alumina. As an example, Figs. 7A and 7B show schematic side views illustrating a method for correcting the warpage of a SiC polycrystalline film 100. In Fig. 7A, the disk-shaped SiC polycrystalline film 100 is warped with a concave center and an upright periphery, and has a convex spherical surface 110 with the center protruding downward, and a concave spherical surface 120 on the opposite side of the spherical surface 110 with the center concave downward. The SiC polycrystalline film 100 is placed on the correction jig 200 so that the spherical surface 110 of the SiC polycrystalline film 100 is in contact with the correction surface 210 of the correction jig 200, and the weight 300 is placed on the SiC polycrystalline film 100 so that the spherical surface 120 of the SiC polycrystalline film 100 is in contact with the spherical surface 310 of the weight 300 (FIG. 7B). This state is maintained while heat treatment is performed.

The correction surface 210 of the correction jig 200 is a convex spherical surface that protrudes upward. If the diameter of the SiC polycrystalline film 100 is 6 inches, the radius of curvature of the correction surface 210 may be 5.0 m or less, and from the viewpoint of effectively correcting the warp of the SiC polycrystalline film 100, it is preferably 4.5 m to 3.0 m. In addition, the center 220 of the correction surface 210 protrudes the most on the correction surface 210, and from the viewpoint of effectively correcting the warp of the SiC polycrystalline film 100, it is preferable that the center 220 protrudes 0.6 mm to 0.8 mm from the outer periphery 230 of the correction surface 210.

The weight is not limited in shape or weight as long as it can be installed so that the entire surface of the spherical surface 110 of the SiC polycrystalline film 100 is in close contact with the entire surface of the correction surface 210 of the correction jig 200. In addition, the weight may be made of a material such as graphite or alumina. For example, the spherical surface 310 of the weight 300 is a concave spherical surface that is concave upward, and may have a concave spherical shape that matches the convex spherical shape of the correction surface 210. By making the shape match the spherical shape, scratches, etc. on the SiC polycrystalline film 100 can be prevented. In order to make the shape conform to such a spherical shape, the radius of curvature of the spherical surface 310 may be 5.0 m or less, and from the viewpoint of effectively correcting the warp of the SiC polycrystalline film 100, it is preferably 4.5 m to 3.0 m. In addition, the center 320 of the spherical surface 310 is the most recessed part of the spherical surface 310, and from the viewpoint of effectively correcting the warp of the SiC polycrystalline film 100, it is preferable that the center 320 is recessed 0.6 mm to 0.8 mm from the outer periphery 330 of the spherical surface 310.

The weight of the weight is not particularly limited as long as it is placed so that the entire surface of the spherical surface 110 of the SiC polycrystalline film 100 is in close contact with the entire surface of the correction surface 210 of the correction jig 200. For example, if the thickness of the SiC polycrystalline film 100 is 1.0 mm or less, the weight of the weight 300 may be 3 kg or more and 8 kg or less, and preferably 4 kg or more and 6 kg or less. If the weight of the weight 300 is less than 3 kg, the warp of the SiC polycrystalline film 100 may not be sufficiently corrected. In addition, if the weight of the weight 300 exceeds 8 kg, the SiC polycrystalline film 100 may crack.

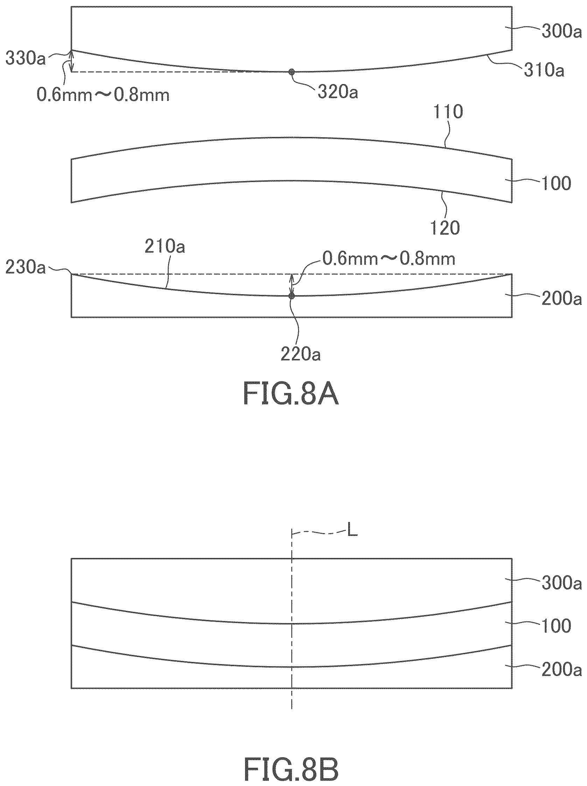

Figures 8A and 8B are schematic side views showing a method for correcting warpage of the SiC polycrystalline film 100, different from that of Figures 7A and 7B. Unlike the cases of Figures 7A and 7B, the SiC polycrystalline film 100 is placed on the correction jig 200a with the spherical surface 120 facing down so as to be in contact with the correction surface 210a of the correction jig 200a, and further the weight 300a is placed on the SiC polycrystalline film 100 so as to be in contact with the spherical surface 110 of the SiC polycrystalline film 100 and the spherical surface 310a of the weight 300a (FIG. 8B). Heat treatment may be performed while maintaining this state.

The correction surface 210a of the correction jig 200a is a concave spherical surface that is concave downward. If the diameter of the SiC polycrystalline film 100 is 6 inches, the radius of curvature of the correction surface 210a may be 5.0 m or less, and from the viewpoint of effectively correcting the warp of the SiC polycrystalline film 100, it is preferably 4.5 m to 3.0 m. Moreover, the center 220a of the correction surface 210a is the most recessed on the correction surface 210a, and from the viewpoint of effectively correcting the warpage of the SiC polycrystalline film 100, it is preferable that the center 220a is recessed by 0.6 mm to 0.8 mm from the outer periphery 230a of the correction surface 210a.

Furthermore, the spherical surface 310a of the weight 300a is a convex spherical surface that protrudes downward, and may have a convex spherical shape that matches the concave spherical shape of the correction surface 210a. By making the shape match the spherical shape, it is possible to prevent scratches, etc. from occurring on the SiC polycrystalline film 100. In order to obtain a shape suitable for such a spherical shape, the radius of curvature of the spherical surface 310a may be 5.0 m or less, and from the viewpoint of effectively correcting the warp of the SiC polycrystalline film 100, it is preferably 4.5 m to 3.0 m. In addition, the center 320a of the spherical surface 310a is the most protruding part of the spherical surface 310a, and from the viewpoint of effectively correcting the warp of the SiC polycrystalline film 100, it is preferable that the center 320a protrudes 0.6 mm to 0.8 mm from the outer periphery 330a of the spherical surface 310a.

For example, if the thickness of the SiC polycrystalline film 100 is 1.0 mm or less, the weight of the weight 300a may be 3 kg or more and 8 kg or less, and preferably 4 kg or more and 6 kg or less. If the weight of the weight 300a is less than 3 kg, the warp of the SiC polycrystalline film 100 may not be sufficiently corrected. In addition, if the weight of the weight exceeds 8 kg, the SiC polycrystalline film 100 may crack.

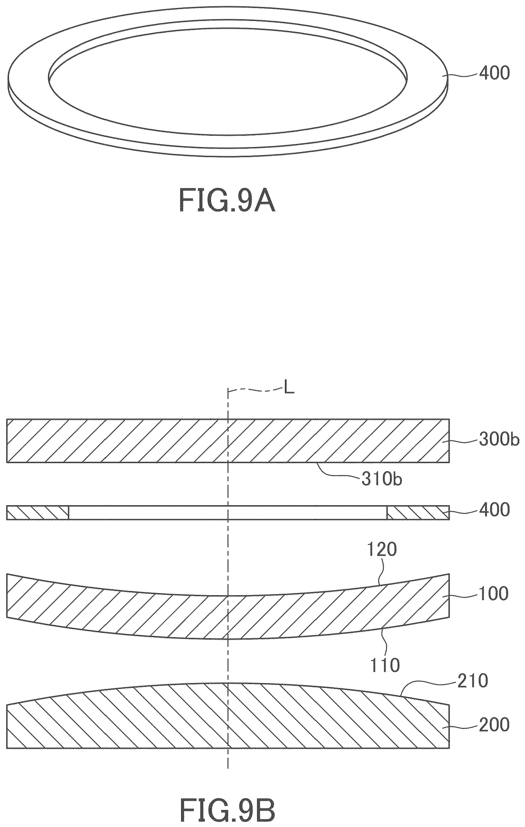

In order to correct the warp of the SiC polycrystalline film 100, it is effective to apply a force in the opposite direction to the warp direction of the SiC polycrystalline film 100 by pressing the periphery of the SiC polycrystalline film 100 with a weight to warp the film in the opposite direction to the warp of the SiC polycrystalline film 100. For this reason, a weight 300b may be placed so as to press the periphery of the SiC polycrystalline film 100 via a ring-shaped jig 400 shown in FIG. 9A (FIG. 9B). In addition, by using the ring-shaped jig 400, it is not necessary to step the lower surface of the weight into a spherical shape, so that a weight 300b with a flat lower surface 310b that can be easily manufactured can be used. The ring-shaped jig 400 can be made of a material such as graphite or alumina. A weight with a ring-shaped bottom surface may be used so that it contacts only the peripheral portion of the SiC polycrystalline film 100.

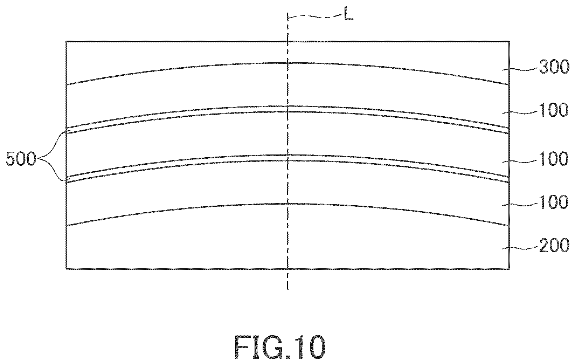

The warping of the SiC polycrystalline film 100 can also be corrected by simultaneously correcting multiple SiC polycrystalline film 100. For example, as shown in FIG. 10, multiple carbon sheets 500 may be inserted between multiple SiC polycrystalline films 100 to stack them, and the warping may be corrected using a correction jig 200 and a weight 300. By placing the carbon sheet 500 between the SiC polycrystalline films 100, adhesion between the SiC polycrystalline films 100 due to sublimation and recrystallization of the surfaces of the SiC polycrystalline films 100 when the SiC polycrystalline films 100 are heat-treated can be suppressed or prevented.

As shown by the dotted line L in Figs. 7B, 8B, 9B, and 10, in any case, the correction jig 200, the SiC polycrystalline film 100, and the weight 300 are stacked so that the center of the spherical surface 110 of the SiC polycrystalline film 100, the center of the correction surface 210 of the correction jig 200, and the center of the spherical surface 310 of the weight 300 are on the same straight line, and the straight line (dotted line L in Figs. 7B, 8B, 9B, and 10) is parallel to the vertical direction, thereby ensuring that the warpage of the SiC polycrystalline film 100 can be corrected.

The heat treatment step is performed after the separation step of step S20 and before the back grinding step (step S110). The heat treatment of the SiC polycrystalline substrate 1 is possible, for example, in the manufacturing step of the SiC polycrystalline substrate, the manufacturing step of the SiC bonded substrate 3, or the manufacturing step of the substrate 6 for a SiC semiconductor device and before the back grinding step. However, as described later, if the heat treatment temperature of the SiC polycrystalline film exceeds 1700°C, the sublimation and recrystallization of SiC on the surface of the SiC polycrystalline substrate begins, and the surface is altered. For this reason, it is preferable to perform the heat treatment in the manufacturing step of the SiC polycrystalline substrate, and in particular, by performing the heat treatment before the grinding step (step S40) of the SiC polycrystalline substrate, defects such as surface deterioration caused by the heat treatment can be eliminated in the grinding step (step S40). In addition, the heat treatment step can reduce the warpage after back grinding.

In step S30, the SiC polycrystalline film after the separation step is heat treated by holding it at 1600°C or higher and 2000°C or less. This step may be a step of holding the SiC polycrystalline film at 1700°C to 1800°C for 3 hours or more.

The higher the heat treatment temperature of the SiC polycrystalline film, the smaller the warpage of the substrate after the back grinding step tends to be. The heat treatment can reduce the internal stress during the formation of the SiC polycrystalline substrate and reduce the warpage of the substrate. If the heat treatment temperature is lower than 1600°C, the effect of improving the warpage of the substrate after the back grinding step is small. If the heat treatment temperature is 1700°C or higher, sublimation and recrystallization of SiC will begin from the surface layer of the SiC polycrystalline film, and if it exceeds 1800°C, the sublimation and recrystallization of SiC will tend to proceed excessively. If the heat treatment temperature exceeds 2000°C, crater-like pores or depressions of several µm to several tens of µm may be formed on the surface layer of the SiC polycrystalline film, which is undesirable because it may cause problems in the formation of the back electrode. It is preferable to perform the heat treatment while holding the polycrystalline film at 1700°C or higher and 1800°C or lower.

The holding time for holding the SiC polycrystalline film at 1600°C or higher and 2000°C or lower is preferably 3 hours or more. If the holding time is less than 3 hours, the effect of improving the warpage of the substrate after back polishing may be small. There is no particular limit to the upper limit of the holding time, but it is preferably 30 hours or less. If the holding time exceeds 30 hours, the effect will not increase any more, and the longer the holding time, the greater the disadvantage in terms of manufacturing costs. The holding time is preferably 20 hours or more and 30 hours or less.

The atmosphere of the SiC polycrystalline film during the heat treatment is preferably at least one of an inert gas such as argon (Ar) or nitrogen (N) or a vacuum atmosphere so as to prevent unnecessary reactions such as oxidation. For example, it is desirable that the heat treatment furnace used for the heat treatment is in a state where an inert gas is flowing, and the flow rate is not limited as long as the furnace is sufficiently filled with inert gas. The heat treatment may be performed using an atmosphere-controlled heating furnace or the like.

### <Steps S40 (grinding step), S50 (polishing step)>

In step 40, the SiC polycrystalline film is ground to a predetermined thickness. Then, in step 50, the surface of the SiC polycrystalline film is polished. After these grinding and polishing steps, the SiC polycrystalline substrate is ready to be bonded to a SiC single crystal substrate 2, which is the SiC polycrystalline substrate 1 of the embodiment of the present invention that can be used as a support substrate.

### [Method of manufacturing a SiC bonded substrate]

### <Steps S60 to S80>

Steps S60 to S80 are a method of manufacturing a SiC bonded substrate. In step S60, the above-mentioned SiC polycrystalline substrate 1 is bonded to a separately prepared SiC single crystal substrate 2 (bonding step). The SiC single crystal substrate 2 may be prepared by bonding a thick SiC single crystal substrate to a support substrate (step 60) using a hydrogen atom ablation peeling technique (also called Smart Cut (registered trademark)) as described in Patent Literature 1, and then separating the substrate to prepare a thin SiC single crystal substrate 2 on the support substrate (step 70). After that, in step S80, a polishing step is performed to polish the surface of the SiC single crystal substrate 2, resulting in a SiC bonded substrate 3 including the SiC polycrystalline substrate 1 and the SiC single crystal substrate 2.

The bonded SiC single crystal substrate 2 may be a SiC single crystal produced by the improved Lely method, or a SiC single crystal formed by the CVD method.

### [Method of Manufacturing SiC Semiconductor Device]

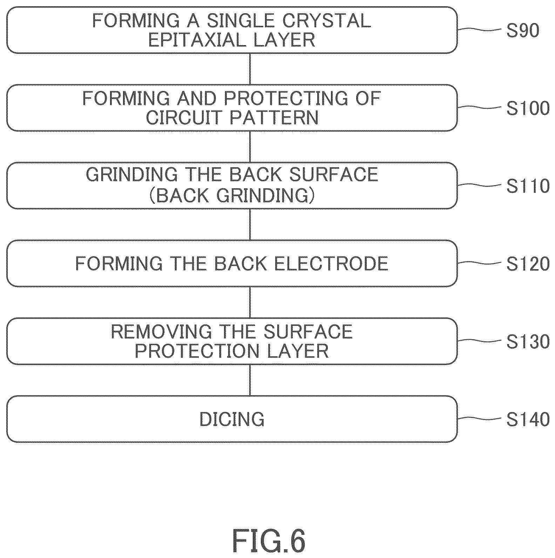

Next, a method of manufacturing the SiC semiconductor device will be described. FIG. 6 is a flow chart showing an example of a method of manufacturing the SiC semiconductor device 7, showing steps S90 to S140. In step S90, the SiC single crystal epitaxial layer 4 is epitaxially grown on the surface of the SiC single crystal substrate 2, and in step S100, a circuit pattern of the semiconductor element component 5 and the like is formed on the surface of the SiC single crystal epitaxial layer 4, and a surface protection layer for protecting the circuit pattern is formed with resin or the like. Thereafter, in step S110, the back side opposite to the side on which the circuit pattern is formed is ground to thin the SiC polycrystalline substrate 1 and form a ground surface 16 (back grinding step). The substrate in the state in which the step up to step S110 has been completed is the substrate 6 for a SiC semiconductor device shown in FIG. 3. After the step of step S110, in step S120, a drain electrode 8 is formed as a back electrode on the ground surface 16 of the substrate 6 for a SiC semiconductor device, resulting in a SiC semiconductor device 7. Note that before forming the back electrode, the ground surface 16 may be subjected to surface processing such as polishing.

Then, in step S130, the surface protection layer protecting the circuit pattern of the SiC semiconductor device 7 is removed, and in step S140, dicing is performed to cut the SiC semiconductor device 7 into dies using a rotating diamond blade or the like.

The process flow from manufacturing the SiC polycrystalline substrate 1 to manufacturing the semiconductor device is as shown in steps S10 to S140, but existing inspection and processes such as contact hole formation and probe inspection may be performed as appropriate.

In the manufacturing step of the SiC semiconductor device 7, after the semiconductor element component 5 are formed on the SiC single crystal epitaxial layer 4, back grinding is performed to grind the back surface. In particular, the SiC semiconductor device 7 is often used in vertical power devices in which the current flow direction is the thickness direction of the substrate, and a thinning step is performed by back grinding after mounting the surface circuit pattern in the manufacturing step of the vertical power device. In this step, it is necessary to remove about 40 % to 60 % of the original thickness of the SiC polycrystalline substrate 1. For example, in the case of a 6-inch diameter SiC polycrystalline substrate, if the substrate thickness is 350 µm, a thickness of about 150 µm to 200 µm is removed by grinding, so the grinding amount of SiC polycrystalline is large, and grinding is generally used, which has a higher thinning efficiency than polishing. For example, in a substrate for a SiC semiconductor device using a SiC single crystal substrate 2 that is not bonded to a SiC polycrystalline substrate, the warp of the substrate after thinning the SiC single crystal substrate 2 by back grinding can be suppressed to about 1 mm or less. By suppressing it within this range, it becomes possible to process the substrate without any problems in the subsequent step. In contrast, in the conventional technology that does not perform a heat treatment step, the warp of the substrate after thinning the SiC polycrystalline substrate 1 by back grinding using a SiC bonded substrate 3 in which a SiC polycrystalline substrate 1 and a SiC single crystal substrate 2 are bonded was, for example, in a state that greatly exceeds 1.0 mm.

In this embodiment, by performing a heat treatment step between the separation step and the grinding step, the warp of the substrate after the thinning of the SiC polycrystalline substrate by back grinding can be suppressed to about 1.0 mm or less.

### Examples

This embodiment will be explained in more detail below by showing examples, but the present invention is not limited to the following examples.

### [Example 1]

### <Preparation of SiC polycrystalline substrate 1>

A seed substrate formed in a disk shape made of carbon was used as a base substrate, and a SiC polycrystalline film with a thickness of 2 mm was formed on the surface of the base substrate by chemical vapor deposition (CVD) (step S10). Methyl chlorosilane was used as the source gas, and hydrogen and nitrogen gases were used as the carrier gas. The growth temperature in this chemical vapor deposition method was 1400°C. After that, the base substrate was heated and removed in an air atmosphere at 1000°C by a combustion method, and a disk-shaped SiC polycrystalline film 100 with a diameter of 6 inches was produced (step S20).

The SiC polycrystalline film 100 was heat-treated using an atmosphere-controlled heating furnace (step S30). The heating temperature was 1700°C, the temperature was held for 24 hours, and the atmosphere in the furnace was an argon gas atmosphere. During the heat treatment, the warpage of the SiC polycrystalline film 100 was corrected using a graphite correction jig 200, a graphite ring-shaped jig 400, and a graphite weight 300b. At this time, the SiC polycrystalline film 100 was first placed on the correction jig 200, the upper surface of which was the correction surface 210. The radius of curvature of the correction surface 210 was 4 m, and the convex spherical surface 110 with the center of the SiC polycrystalline film 100 protruding was placed on the correction surface 210. A ring-shaped jig 400 with an outer diameter of 150 mm, an inner diameter of 100 mm, and a plate thickness of 2 mm was placed on the SiC polycrystalline film 100 placed on the correction jig 200 in this way, and a cylindrical weight 300b weighing 4 kg was placed on the ring-shaped jig 400. By arranging them in this way, the spherical surface 110 of the SiC polycrystalline film 100 was deformed so as to be in close contact with the correction surface 210, and a force was applied in the opposite direction to the warping direction of the SiC polycrystalline film 100, so that the heat treatment was performed while maintaining the warped state in the opposite direction. Note that the warping direction of the SiC polycrystalline film 100 before being placed on the correction jig 200 can be determined by using a shape measuring device such as the above-mentioned three-dimensional measuring device, as well as by various simple measurements and visual inspection.

Then, the surface of the SiC polycrystalline film 100 was ground and polished to be flat (steps S40 and S50), and a SiC polycrystalline substrate 1 having a diameter of 6 inches (about 150 mm) and a thickness of 350 µm was obtained.

### <Preparation of SiC bonded substrate 3>

The manufactured SiC polycrystalline substrate 1 was used to prepare a SiC bonded substrate 3. As the SiC single crystal substrate 2 to be bonded to the SiC polycrystalline substrate 1, a disk-shaped substrate of 4H polytype with a thickness of 350 µm, a diameter of 6 inches (about 150 mm) and a main surface orientation of <0001>, manufactured by the improved Lely method, was used. In addition, in manufacturing the SiC bonded substrate 3, a peeling technique using hydrogen atom ablation (also called Smart Cut (registered trademark)) described in Patent Literature 1 was used.

### (Step S60)

Hydrogen ions were implanted into the bonding surface of the SiC single crystal substrate 2 to be bonded to the SiC polycrystalline substrate 1, and a hydrogen ion implanted layer was formed at a depth of 1.0 µm from the bonding surface. The SiC single crystal substrate 2 and the SiC polycrystalline substrate 1 were attracted by an electrostatic chuck and set in a chamber. Next, the electrostatic chuck was moved to align the relative positions of the SiC single crystal substrate 2 and the SiC polycrystalline substrate 1 so that the two substrates can be in contact with each other in the room temperature bonding step in the correct positional relationship. Next, the chamber was evacuated to a vacuum of 2×10⁻⁶ Pa. Next, a neutral atomic beam of argon was uniformly irradiated to the entire surface of the bonding surface of the SiC single crystal substrate 2 and the entire surface of the bonding surface of the SiC polycrystalline substrate 1 using a FAB gun, and the oxide films and adsorption layers of both bonding surfaces were removed to expose the bonds and activate them. Next, while maintaining the vacuum state at room temperature, the electrostatic chuck was moved in the chamber, and the bonding surfaces of the SiC single crystal substrate 2 and the SiC polycrystalline substrate 1 were brought into contact with each other in the vacuum state in the chamber and directly bonded by covalent bonds to obtain a bonded substrate.

### (Step S70)

Next, the bonded substrate was heated to 1000°C in an inert atmosphere filled with argon gas using a furnace to form a microbubble layer in the hydrogen ion implantation layer, and the SiC single crystal substrate 2 was separated at the microbubble layer, and a thin plate-shaped SiC single crystal substrate 2 with a thickness of 1.0 µm was transferred to the SiC polycrystalline substrate 1.

### (Step S80)

The surface of the SiC single crystal substrate 2 exposed in step S70 was processed by CMP polishing so as to be smooth. As a result, a SiC bonded substrate 3 was obtained.

### <Preparation of a substrate 6 for a SiC semiconductor device>

Next, a substrate 6 for a SiC semiconductor device was prepared. Using the SiC bonded substrate 3 manufactured by the above method, a SiC single crystal epitaxial layer 4 was formed to a thickness of 20 µm on the surface of the SiC single crystal substrate 2 by chemical vapor deposition (step S90). After that, a circuit pattern was formed as the semiconductor element component 5 on the surface of the SiC single crystal epitaxial layer 4, and the circuit pattern was protected with a resin or the like (step S100). After that, the exposed surface side of the SiC polycrystalline substrate 1 was ground to form a ground surface 16 (step S110). The back grinding was performed by grinding the back surface of the SiC polycrystalline substrate 1 using a grinder manufactured by DISCO. The grinding wheel used for grinding was a 7000-number grinding wheel with a diameter of 200 mm.

### <Measurement of warpage of ground surface 16>

The measurement of warpage of the substrate 6 for a SiC semiconductor device was performed using a three-dimensional measuring device EMS-3D 300XY manufactured by COMS Co., Ltd. First, the ground surface 16 of the substrate 6 for a SiC semiconductor device was sucked on the non-full surface, and the height difference data in the ground surface 16 was obtained while the semiconductor element component 5 of substrate 6 for a SiC semiconductor device was held facing upward. Next, the warpage was calculated as the sum of the maximum and minimum distances from the reference plane. The warpage was measured in the state before grinding in step S110, the state in which the back grinding amount of the SiC polycrystalline substrate 1 in step S110 was 150 µm (43 % of the thickness of the SiC polycrystalline substrate 1), the state in which it was 175 µm (50 % of the thickness of the SiC polycrystalline substrate 1) and the state in which it was 200 µm (57 % of the thickness of the SiC polycrystalline substrate 1). The measurement results are shown in Table 1.

The non-full surface is an adhesion surface that can suck and hold three points or one point of the measurement target surface to be measured for warpage without changing the original shape of the substrate, and since the entire surface of the measurement target surface is not sucked, the use of the non-full surface makes it possible to measure the warpage.

### [Example 2]

In Example 2, the warpage of the SiC polycrystalline substrate 1 produced in Example 1 was evaluated. First, to evaluate the back grinding, the SiC polycrystalline substrate 1 was subjected to a back grinding step under the same conditions as in step S110 in Example 1. In addition, the warpage of the opposite surface 12 of the SiC polycrystalline substrate 1 before the back grinding step, and the ground surface 13 in a state where the back grinding amount of the SiC polycrystalline substrate 1 was 150 µm (43 % of the thickness of the SiC polycrystalline substrate 1), a state where the back grinding amount was 175 µm (50 % of the thickness of the SiC polycrystalline substrate 1) and a state where the back grinding amount was 200 µm (57 % of the thickness of the SiC polycrystalline substrate 1) were measured by adsorbing and holding the opposite surface 12 and the ground surface 13 with a non-full adsorption surface. The measurement results are shown in Table 1.

### [Example 3], [Example 4]

In Example 3, the radius of curvature of the correction surface 210 of the correction jig 200 in the heat treatment step was changed to 3.5 m. In Example 4, the heat treatment temperature in the heat treatment step was changed to 1,800°C. Except for the above changes, the warpage of the SiC polycrystalline substrate 1 produced under the same conditions as those for producing the SiC polycrystalline substrate 1 in Example 1 was evaluated. As in Example 2, the back grinding step was performed, and the opposite surface 12 and the ground surface 13 were adsorbed and held by the non-full adsorption surface to measure the warpage of the opposite surface 12 and the ground surface 13. That is, the warpage of the opposite surface 12 of the SiC polycrystalline substrate 1 before the back grinding step was measured, and the warpage of the ground surface 13 was measured in the state where the back grinding amount of the SiC polycrystalline substrate 1 was 150 µm (43 % of the thickness of the SiC polycrystalline substrate 1), 175 µm (50 % of the thickness of the SiC polycrystalline substrate 1), and 200 µm (57 % of the thickness of the SiC polycrystalline substrate 1). The measurement results are shown in Table 1.

### [Comparative Example 1]

Except for not carrying out the heat treatment step of step S30, the SiC polycrystalline substrate 1, the SiC bonded substrate 3, and the substrate 6 for a SiC semiconductor device were manufactured in the same manner as in Example 1, and the warpage of the substrate 6 for a SiC semiconductor device was measured. The measurement results are shown in Table 1.

### [Comparative Example 2]

The warpage of the SiC polycrystalline substrate 1 manufactured in Comparative Example 1 was measured in the same manner as in Example 2. The measurement results are shown in Table 1.

### [Comparative Example 3]

The warpage of the SiC bonded substrate 3 manufactured in Comparative Example 1 was measured. Specifically, a backgrinding step was performed on the SiC bonded substrate 3 under the same conditions as in step S110 of Example 1. In addition, the warpage of the back surface 14 of the SiC bonded substrate 3 before the back grinding step was measured, and the warpage of the ground surface 15 was measured in the state where the back surface grinding amount of the SiC bonded substrate 3 was 150 µm (43 % of the thickness of the SiC polycrystalline substrate 1), 175 µm (50 % of the thickness of the SiC polycrystalline substrate 1), and 200 µm (57 % of the thickness of the SiC polycrystalline substrate 1). The warpage was measured by suctioning and holding the back surface 14 and the ground surface 15 on the non-full suction surface. The measurement results are shown in Table 1.

### [Comparative Example 4]

In Comparative Example 4, the correction jig 200, the ring-shaped jig 400, and the weight 300b were not used in the heat treatment step, and the heat treatment was performed without correcting the warpage of the SiC polycrystalline film 100. Otherwise, the SiC polycrystalline substrate 1 was produced under the same conditions as those for producing the SiC polycrystalline substrate 1 in Example 1, and the warpage of the SiC polycrystalline substrate 1 was evaluated. The opposite surface 12 of the SiC polycrystalline substrate 1 before the back grinding step and the ground surface 13 after the back grinding step which were performed as in Example 2 were adsorbed and held on the non-full surface, and the warpage of the opposite surface 12 and the ground surface 13 were measured. The measurement results are shown in Table 1.

**[Table 1]**

| Classification Example or Comparative Example | Substrate Type | Heat Treatment Conditions | | | Before B. G. Processing | Thickness of SiC Polycrystalline Substrate After B. G. Processing | | |
|---|---|---|---|---|---|---|---|---|
| | | | | | | Plate Thickness of 200 µm | Plate Thickness of 175 µm | Plate Thickness of 150 µm |
| | | Temperature [°C] | Retention Time [hr.] | Radius of Curvature of The Correction Surface [m] | Warp[µm] | Warp[µm] | Warp[µm] | Warp[µm] |
| Comparative Example 1 | Substrate for semiconductor device | None | None | - | 59.0 | 1022.6 | 1181.0 | 1429.8 |
| Comparative Example 2 | SiC Polycrystal Substrate | None | None | - | 46.5 | 1030.5 | 1176.7 | 1529.0 |
| Comparative Example 3 | SiC bonded substrate | None | None | - | 56.4 | 1013.6 | 1152.7 | 1444.5 |
| Comparative Example 4 | SiC Polycrystal Substrate | 1700 | 24 | - | 20.7 | 564.0 | 850.6 | 1183.1 |
| Example 1 | Substrate for semiconductor device | 1700 | 24 | 4.0 | 43.3 | 453.3 | 470.5 | 943.2 |
| Example 2 | SiC Polycrystal Substrate | 1700 | 24 | 4.0 | 30.0 | 420.1 | 442.9 | 923.4 |
| Example 3 | SiC Polycrystal Substrate | 1700 | 24 | 3.5 | 85.3 | 410.3 | 435.1 | 920.7 |
| Example 4 | SiC Polycrystal Substrate | 1800 | 24 | 4.0 | 36.7 | 405.7 | 421.0 | 913.5 |

### (Results and Discussion)

The substrate 6 for a SiC semiconductor device is composed of a SiC polycrystalline substrate 1, a SiC single crystal substrate 2, a SiC single crystal epitaxial layer 4, and a semiconductor element component 5. Among these, the thickness of the SiC polycrystalline substrate 1 is sufficiently larger than the others, and the SiC polycrystalline substrate 1 is directly processed during back grinding, so it can be seen that the SiC polycrystalline substrate 1 has a large effect on warpage.

In addition, in the results of Table 1, the degree of warpage after back grinding ("After B. G. Processing" in Table 1) was significantly greater than the warpage before back grinding ("Before B. G. Processing" in Table 1) in any of the cases of the substrate 6 for a SiC semiconductor device, the SiC bonded substrate 3, and the SiC polycrystalline substrate 1. This shows that the warpage of the substrate caused by back grinding requires improvement of the warpage of the SiC polycrystalline substrate 1 after back grinding. Comparing Examples 1 to 4 and Comparative Examples 1 to 4 in Table 1, it was found that the warpage could be improved by subjecting the SiC polycrystalline substrate 1 to heat treatment.

In Comparative Examples 1 to 3, the warpage after back grinding exceeds 1 mm in each of the substrate 6 for a SiC semiconductor device, the SiC bonded substrate 3, and the SiC polycrystalline substrate 1, because no heat treatment step is performed. Also, the warpage after back grinding of the substrate 6 for a SiC semiconductor device, the SiC bonded substrate 3, and the SiC polycrystalline substrate 1 is almost the same. From this result, it is inferred that the warpage after back grinding of the substrate 6 for a SiC semiconductor device is essentially caused by the SiC polycrystalline substrate 1. From the results of Examples 1 to 4, it was found that the warpage after back grinding of the substrate 6 for a SiC semiconductor device can also be improved by improving the warpage after back grinding of the SiC polycrystalline substrate 1 alone by heat treatment (Examples 1 to 4).

In addition, by performing heat treatment while maintaining the state in which the warpage of the SiC polycrystalline film 100 was corrected using the correction jig 200, the ring-shaped jig 400, and the weight 300b, that is, the state in which a force was applied in the opposite direction to the direction of the warpage of the SiC polycrystalline film 100, the degree of warpage could be improved more than when heat treatment was performed without correcting the warpage of the SiC polycrystalline film 100 (Examples 1 to 4, Comparative Example 4).

As described above, this embodiment can reduce the warpage of a 6-inch substrate after back grinding to 1 mm or less by back grinding, and this embodiment can provide a manufacturing method that can achieve this by a heat treatment step characterized by a long time and high temperature, which is industrially useful. The heat treatment conditions for reducing the warpage of a 6-inch substrate after back grinding to 1 mm or less by back grinding step are a heat treatment temperature of 1600°C or more and 2000°C or less, and a temperature holding time of 3 hours or more. In addition, by performing heat treatment while maintaining the state in which the warpage of the SiC polycrystalline film is corrected, the warpage of the substrate after back grinding by back grinding step can be further alleviated.

### Reference Signs List

1, 1A...SiC polycrystalline substrate, 2...SiC single crystal substrate, 3, 3A...SiC bonded substrate, 4...SiC single crystal epitaxial layer, 5... semiconductor element component, 6...substrate for SiC semiconductor device, 7...SiC semiconductor device, 8...drain electrode, 11...surface, 12...opposite surface, 13, 15, 16...ground surface, 14...back surface, 51...source electrode, 52...gate electrode, 53...gate insulating film, 54...N⁺ Source, 55...P well, 100...SiC polycrystalline film, 110, 120...spherical surface, 200, 200a...correction jig, 210, 210a...correction surface, 220, 220a, 320, 320a...center, 230, 230a...periphery, 300, 300a, 300b...weight, 310, 310a...spherical surface, 310b...lower surface, 330, 330a...periphery, 400...ring-shaped jig, 500...carbon sheet.

## Claims

1. A substrate for a SiC semiconductor device, wherein the substrate is formed by stacking
a support substrate made of SiC polycrystalline,
a SiC single crystal substrate bonded to a surface of the support substrate,
a SiC single crystal epitaxial layer formed on the surface of the SiC single crystal substrate, and
a semiconductor element component formed on the SiC single crystal epitaxial layer, in this sequence,
wherein the surface of the support substrate that is not bonded to the SiC single crystal substrate is a ground surface, and
wherein an amount of warping of the ground surface relative to a diameter of the ground surface is 0.17 mm/inch or less.

2. The substrate for a SiC semiconductor device according to claim 1, wherein the amount of warping of the ground surface is 1.0 mm or less.

3. A SiC bonded substrate, wherein the substrate is formed by stacking
a support substrate made of SiC polycrystalline, and
a SiC single crystal substrate bonded to a surface of the support substrate,
wherein an amount of warping of a ground surface relative to a diameter of the ground surface is 0.17 mm/inch or less in state that the thickness of the support substrate is ground by 40 % to 60 % to form the ground surface by performing a back grinding step on the surface of the support substrate that is not bonded to the SiC single crystal substrate.

4. The SiC bonded substrate according to claim 3, wherein the amount of warping of the ground surface is 1.0 mm or less.

5. The SiC bonded substrate according to claim 3, wherein the amount of warping of the ground surface relative to the diameter of the ground surface is 0.085 mm/inch or less in state that the thickness of the support substrate is ground by 40 % to 50 % to form the ground surface by performing the back grinding step on the surface of the support substrate that is not bonded to the SiC single crystal substrate.

6. A SiC polycrystalline substrate used as a support substrate for a SiC bonded substrate, wherein the substrate is formed by stacking
the support substrate made of SiC polycrystalline, and
a SiC single crystal substrate bonded to a surface of the support substrate,
wherein an amount of warping of a ground surface relative to a diameter of the ground surface is 0.17 mm/inch or less in state that a thickness of the support substrate is ground by 40 % to 60 % to form the ground surface by performing a back grinding step on the surface of the support substrate that is not bonded to the SiC single crystal substrate.

7. The SiC polycrystalline substrate according to claim 6, wherein the amount of warping of the ground surface is 1.0 mm or less.

8. The SiC polycrystalline substrate according to claim 6, wherein the amount of warping of the ground surface relative to the diameter of the ground surface is 0.085 mm/inch or less in state that the thickness of the support substrate is ground by 40 % to 50 % to form the ground surface by performing the back grinding step on the surface of the support substrate that is not bonded to the SiC single crystal substrate.

9. A method for manufacturing a SiC polycrystalline substrate used as a support substrate for a SiC bonded substrate, wherein the support substrate made of SiC polycrystalline and a SiC single crystal substrate bonded to a surface of the support substrate are stacked, the method comprising:
a film formation step of forming a SiC polycrystalline film on a seed substrate;
a separation step of separating the seed substrate and the SiC polycrystalline film after the film formation step;
a heat treatment step of heat treating the SiC polycrystalline film by holding the SiC polycrystalline film at 1600°C or higher and 2000°C or lower after the separation step; and
a grinding and polishing step of grinding and polishing the SiC polycrystalline film to process it into the support substrate after the heat treatment step,
wherein in the heat treatment step, the SiC polycrystalline film is heat-treated while maintaining a state in which a force is applied in a direction opposite to the direction of warping of the SiC polycrystalline film.

10. The method for manufacturing a SiC polycrystalline substrate according to claim 9, wherein in the heat treatment step, the force applied to an opposite direction is applied to the SiC polycrystalline film placed on a correction jig.

11. The method for manufacturing a SiC polycrystalline substrate according to claim 9, wherein the heat treatment step is a step of holding the SiC polycrystalline film at a temperature between 1700°C and 1800°C for 3 hours or more.
